# EUROPEAN PATENT APPLICATION

(11) **EP 2 043 146 A1**
(43) Date of publication of application: **01.04.2009**
(21) Application number: 08752493.0
(22) Date of filing: 09.05.2008
(51) Int. Cl.: H01L 23/02

(54) **LID OR CASE FOR SEALING PACKAGE AND METHOD FOR MANUFACTURING THE LID OR THE CASE**

(30) Priority: 11.05.2007 JP 2007126336
(71) Applicant: Tanaka Kikinzoku Kogyo K.K., Chiyoda-ku Tokyo 100-6422 (JP)
(72) Inventor: SHIMADA, Tomohiro c/o TANAKA KIKINZOKU KOGYO K.K. Hiratsuka Factory, Kanagawa 254-0076 (JP); MIYAZAKI, Kenichi c/o TANAKA KIKINZOKU KOGYO K.K. Hiratsuka Factory, Kanagawa 254-0076 (JP)
(74) Representative: Moy, David
(86) International application number: PCT/JP2008/058607
(87) International publication number: WO 2008/140033

(57) **Abstract**

The present invention provides a lid or a case for a sealed package, which is provided with a frame-shaped soldering material on its face to be joined, wherein the frame-shaped soldering material is formed of aligned ball-shaped soldering materials having particle sizes of 10 to 300 µm. This lid or case can be manufactured by the steps of: (1) forming a droplet from the soldering material in a molten state; (2) discharging the soldering material which has been formed into the droplet onto the face to be joined of the lid or the case to fix the ball-shaped soldering material on the face; and (3) repeating the steps (1) and (2).

## Description

### Technical Field

The present invention relates to a lid or a case used for a sealed package of various electronic parts.

### Background Art

A lid (cover) or a case (container) for a sealed package of electronic parts which are used in various electronic equipments is generally provided with a soldering material on a face to be joined (which is an end part in the vicinity of four sides thereof in the case of the lid, and is a rim part of an upper end thereof in the case of the case). The electronic parts are manufactured through hermetically sealing the package by melting the soldering material fixed to the lid or the case and joining both to each other.

General aspects of the lid or the case provided with the soldering material include the one having the soldering material mounted on a lid or a case, heated, fusion-bonded thereto and fixed thereon, which has been previously prepared into a composition, worked and molded into such a shape as to fit the shape and area of the face to be joined. In addition, the one is also known which has the soldering material formed into a pasty state in place of a solid soldering material applied, dried and fixed on the lid or the case. A soldering material to be used for sealing the package includes an Au-Sn soldering material and an Au-Ge-based soldering material.
Patent document 1: Japanese Patent Laid-Open No. 2001-176999
Patent document 2: Japanese Patent Laid-Open No. 2004-186428

### Disclosure of the Invention

### Problems to be Solved by the Invention

The above described conventional arts have the problems mentioned below. That is to say, the former soldering material of the lid or the case provided with the soldering material which has been molded and worked is manufactured through many steps of composition preparation, melting, primary working (extruding and rolling) and secondary working (stamping or the like), and accordingly has not been preferable from the viewpoint of the manufacturing cost. There has also been a problem that the material of the Au-Sn-based alloy or the like tends to easily cause a defect such as a crack, and has a limitation in a workable size (thickness) though being not unworkable. In particular, electronic parts are required to lower the height and reduce the thickness, and it is forecasted that the thickness of the electronic parts will be further reduced. In order to respond to the requirement, the sheet thickness of the soldering material needs to be further reduced. However, the soldering material had a limitation in reducing the sheet thickness because the working accuracy is lowered as described above.

On the other hand, when the latter pasty soldering material is applied, there are few problems as described above because a process of applying the paste does not involve a working process. However, the pasty soldering material includes an organic solvent as a dispersion medium. The organic solvent generates a gas when the package is sealed (when the soldering material melts), and therefore could lower the accuracy of the element in the inner part of the package, and may result in breakage in the worst case. Accordingly, it can be said that the pasty soldering material basically is not suitable for hermetically sealing the electronic parts. In this regard, it is prevent a problem of gas generating from the paste, but the operation makes a process for manufacturing the package complicated. Thus, the operation is rather short of a practical countermeasure.

Then, the present invention is directed at providing a lid or a case for sealing a package, which is provided with a different soldering material from a conventional form, can lower the height and reduce the thickness of the package while reducing a manufacturing process, and will not affect negatively the element in the package.

### Means for Solving the Problems

In order to solve the above described problems, the present invention provides a lid or a case for a sealed package, which is provided with a frame-shaped soldering material on a face to be joined, wherein the frame-shaped soldering material is formed of aligned ball-shaped soldering materials having particle sizes of 10 to 300 µm.

The lid or the case according to the present invention has ball-shaped soldering materials having fine particle sizes arrayed on the face to be joined. This ball-shaped soldering material can be formed by directly discharging a soldering material that has been formed into a droplet in a molten state onto the face to be joined, and can fix the soldering material in a few steps, as will be described later. In addition, the particle size of the ball-shaped soldering material can be adjusted when the soldering material is discharged, and the soldering material having the microparticle size can be also formed. Accordingly, the present invention can also cope with the tendency of lowering the height of and reducing the thickness of the package.

Here, the reason of controlling the particle size of the ball-shaped soldering material to 10 µm or more is because when the soldering material having an excessively fine particle is applied, an enormous number of the ball-shaped soldering materials are needed for securing the quantity (volume) of the soldering material necessary for joining, which exerts an influence on manufacturing efficiency. In addition, it is difficult to work an orifice for forming a droplet with a smaller size than 10 µm. On the other hand, when a soldering material to be applied has a particle size exceeding 300 µm, it is difficult to control the thickness of the soldering material which has sealed the package, and the thickness tends to increase. A more preferred particle size of the ball-shaped soldering material is 30 to 120 µm.

The ball-shaped soldering material may be continuously arranged so that the soldering materials contact each other, and may also be arranged so as to be separated from each other at a fixed distance. The lid or the case for a sealed package according to the present invention can effectively lower the height and reduce the thickness of the package, while minimizing the amount (volume) of the soldering material to be used, by appropriately controlling the particle sizes of the soldering materials and the space between the soldering materials to be placed. The ball-shaped soldering material may form a frame shape in a single layer, or the ball-shaped soldering materials may also be stacked.

A conventional soldering material for hermetically sealing a package can be used for the soldering material. In this regard, an Au-Sn soldering material, particularly, an 80 wt% Au - 20 wt% Sn soldering material which is a eutectic composition thereof is conventionally used as a soldering material for sealing, because of having superior reliability and corrosion resistance, and is preferably used in the present invention as well. In addition to the soldering material, an Au-Ge-based soldering material, an Au-Si-based soldering material and an Au-Sb-based soldering material can be applied.

A material similar to conventional material can be used for the lid or the case as well. Specifically, kovar (Fe-Ni-Co-based alloy), 42 alloy (Fe-Ni-based alloy) and a ceramic sheet provided with a metallized layer (alumina or the like provided with metallized layer) are used as the material.

By the way, the lid and the case may be provided with various plated layers on the face to be joined, before a ball-shaped soldering material is fixed thereon. This plated layer is an Ni-plated and/or Au-plated layer which is formed on purpose of securing the corrosion resistance of the lid and the case and securing the wettability of the soldering material when the package is hermetically sealed. The plated layer preferably has the thickness of 1 to 3 µm for the Ni-plated layer, and the thickness of 0.01 to 5 µm for the Au-plated layer.

When a package with the use of the lid and the case according to the present invention is sealed, the ball-shaped soldering material can be used for sealing in the state. Alternatively, the lid and the case may be subjected to a reflowing process before a sealing operation, in which the ball-shaped soldering materials are melted to form a tabular soldering material, and then may be subjected to the sealing operation.

In a manufacturing process of a lid and a case according to the present invention, a ball-shaped soldering material needs to be continuously formed on the face to be joined. A method for manufacturing and fixing the ball-shaped soldering material includes the steps of: preparing the soldering material of which the composition is adjusted; melting the soldering material; forming a droplet from the molten soldering material; and discharging the soldering material which has been formed into a droplet onto a face to be joined of the lid or the case to fix the ball-shaped soldering material on the face. A frame-shaped soldering material can be formed by repeatedly conducting these steps.

The method of keeping the shape of and the space between the soldering materials constant when discharging the soldering material includes keeping the soldering material in a molten state, giving the impact of a fixed pressure to the molten soldering material, and moving the discharge port at a constant speed. The particle size of the molten soldering material to be discharged is preferably equal to the objective particle size of the ball-shaped soldering material to be formed.

The soldering material may be formed on a single lid or case. In other words, the soldering material may be discharged to and fixed on each of the single lid or case which has been manufactured into a predetermined size.

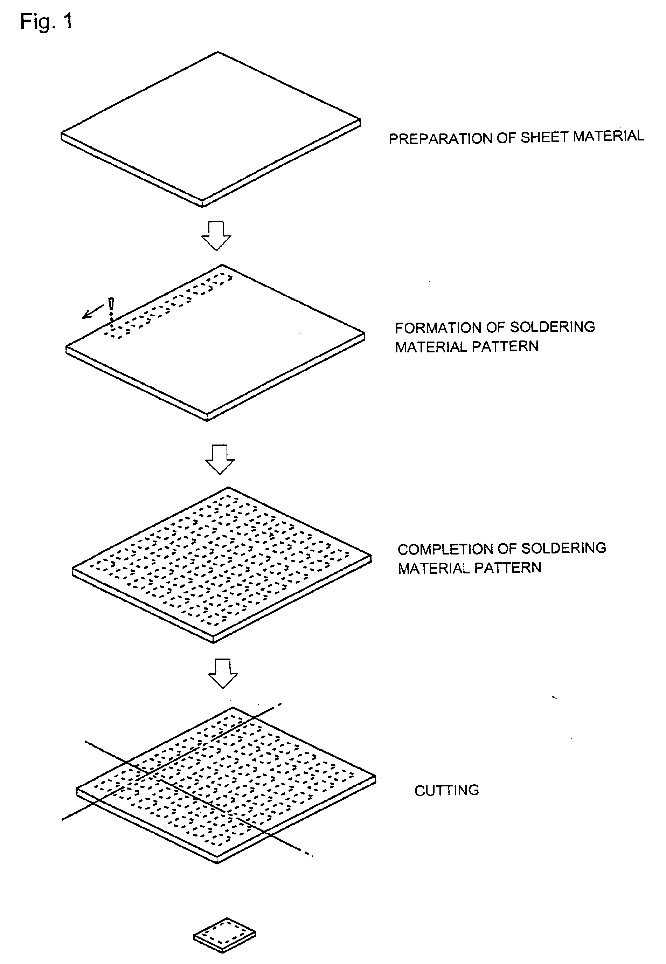

However, these members become finer in the future according to the tendency that electronic parts are being miniaturized, so that it is complicated to form the soldering material on an individual fine lid or case. For this reason, it is preferable to form patterns of a soldering material corresponding to a plurality of lids and cases on one piece of a sheet material, and then separate each part with a cutting method of dicing, using a wire-saw or the like, in order to efficiently manufacture the lid or the case. This method is a process including the steps of: preparing a sheet material comprising a plurality of lids or a base material comprising a plurality of cases; discharging the soldering material which has been made into a droplet, to a face to be joined of each lid, or a portion corresponding to a face to be joined of each case of the above described base material to form the patterns of the soldering material; and cutting the patterns into each lid or case. The overview of these steps is illustrated in Fig. 1.

In addition, when a plurality of the lids or the cases are manufactured at the same time in this way, it is allowed to subject the sheet material or the base material after having had the ball-shaped soldering material fixed sheet material or the base material into individual parts.

By the way, the above described sheet material which has had the pattern of the ball-shaped soldering material formed thereon can be used also as in the state without being divided into individual lids, so as to manufacture the plurality of lids at the same time. The sheet material provided with the patterned soldering material is referred to as a large size of a lid as well. A method for sealing a package with the use of the large-sized lid includes the steps of: preparing a base material which comprises the plurality of the above described cases so as to correspond to a large-sized lid; making an element contained in each case of the material; overlaying the large-sized lid on the base material; then fusion-bonding them with each other through the soldering material; thus sealing a plurality of the packages at the same time; and cutting the packages into each piece. Thus, individual packages can be manufactured. This sealing method is particularly advantageous in being capable of manufacturing a large number of small packages efficiently.

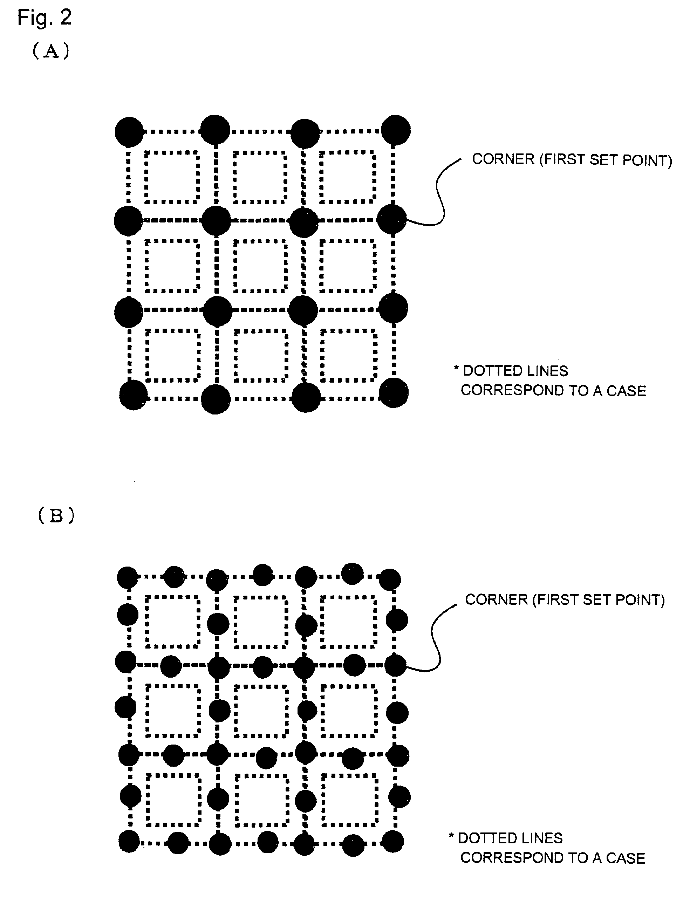

The large-sized lid capable of thus sealing packages collectively is formed of a sheet material which can integrally form a plurality of the lids, and has ball-shaped soldering materials aligned on a face to be joined at which each lid is joined with the case. Here, the ball-shaped soldering materials are preferably arranged on at least a first set point corresponding to the corner part among the lids to be joined (Fig. 2(A)), as an arrangement pattern. It is because the arrangement pattern of the ball-shaped soldering material is appropriate to make the soldering material efficiently spread out to necessary portions, since the soldering material shows a behavior of melting and spreading to every direction during a fusion-bonding step. As long as the ball-shaped soldering material has superior wettability, the ball-shaped soldering material can spread over the whole face to the joined of the lid and the case, by giving an appropriate volume (particle size) to each ball, even though the ball-shaped soldering materials are set only in the first set point.

On the other hand, when the ball-shaped soldering material has insufficient wettability, there is a case where the soldering material does not spread out uniformly. In such a case, the lid and the case can be uniformly joined by further arranging at least one ball-shaped soldering material in between the first set points, in addition to the first set point (Fig. 2(B)).

The above described arrangement of the ball-shaped soldering material is determined according to the wettability depending on the composition of the soldering material and the wettability based on the presence or absence of Au-plated film on the large-sized lid or the like. As for the composition of the ball-shaped soldering material used in the large-sized lid, an Au-Sn-based soldering material, an Au-Ge-based soldering material, an Au-Si-based soldering material and an Au-Sb-based soldering material are used as a soldering material, as is described above. The lid can also be provided with a plated layer for securing its corrosion resistance and wettability. The plated layer is an Ni-plated layer and/or anAu-plated layer. The Ni-plated layer preferably has a thickness of 1 to 3 µm, and the Au-plated layer has a thickness of 0.01 to 5 µm. In addition, the ball-shaped soldering material also has the particle size of 30 to 120 µm, as is described above.

Furthermore, a method for manufacturing the large-sized lid is basically similar to the above described method, and includes the steps of: preparing an integrated sheet material which comprises a plurality of lids; and discharging the soldering material which has been formed into a droplet onto the sheet material to fix the ball-shaped soldering material on the sheet material.

### Brief Description of the Drawings

Fig. 1 is a view for describing a manufacturing process of a lid and a case according to the present invention;
Fig. 2 is a view for describing a fixed position of a ball-shaped soldering material on a large-sized lid;
Fig. 3 is a view illustrating a configuration of an apparatus for forming a soldering material pattern used in a first embodiment;
Fig. 4 is a view illustrating a configuration of a discharge device of an apparatus for forming a soldering material pattern;
Fig. 5 is a view for describing a pretreatment step (Ni plating and Au plating) of a sheet material according to Example 1; and
Fig. 6 is a view for describing a step of collectively sealing a package according to a second embodiment.

### Best Mode for Carrying Out the Invention

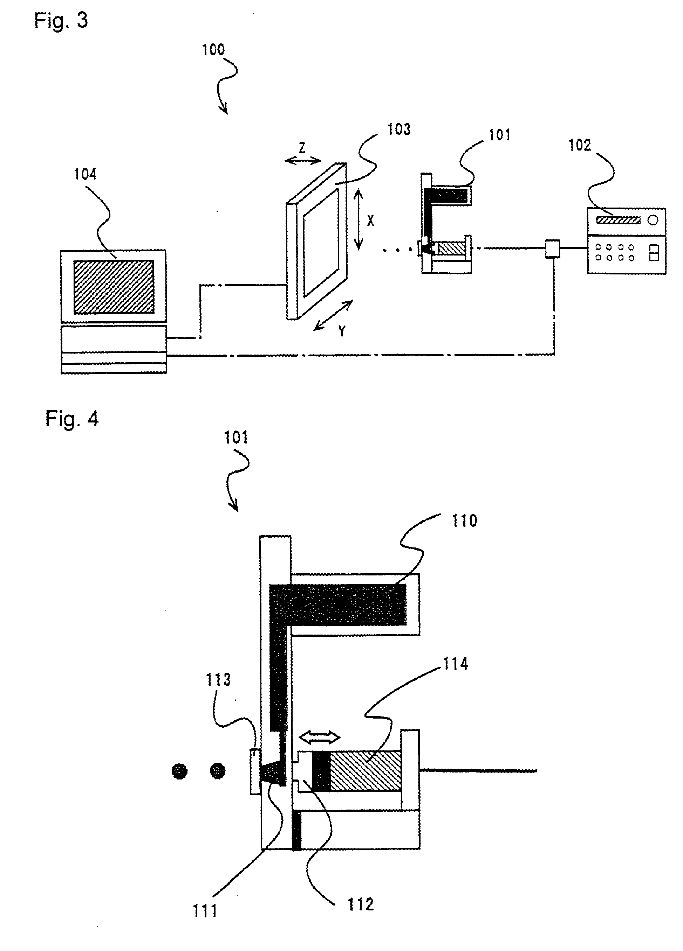

First embodiment: Preferred embodiments according to the present invention will now be described below. Fig. 3 illustrates a configuration of an apparatus for forming a ball-shaped soldering material and a pattern used in the present embodiment. In Fig. 3, the apparatus 100 for forming the pattern of the soldering material includes: a discharge device 101 provided with a nozzle for discharging a soldering material that has been formed into a droplet; a control device 102 for the discharge device 101; an XYZ stage 103 for mounting a lid, a case, a sheet material or the like to be treated thereon; and a computer 104 for controlling the control device 102 and the XYZ stage 103.

Fig. 4 illustrates a more detailed structure of a discharge device 101. The discharge device 101 includes: a tank 110 for accommodating a communicates with the tank 110; a diaphragm 112 and a nozzle 113 for discharging the soldering material existing in the chamber 111; and a piezoelectric element actuator 114 for driving the diaphragm 112.

When the apparatus 100 forms the soldering material pattern, the computer 104 controls an amount of driving the piezoelectric element actuator 114 through the control device 102, and a fixed amount of the soldering material in the chamber 111 is thereby discharged from the nozzle. The computer 104 also moves the XYZ stage 103, and makes the soldering material form the pattern on the lid. The particle size of and the space between the soldering materials on the lid or the case is adjusted by the moved amount of the diaphragm 112 and the moving velocity of the XYZ stage 103.

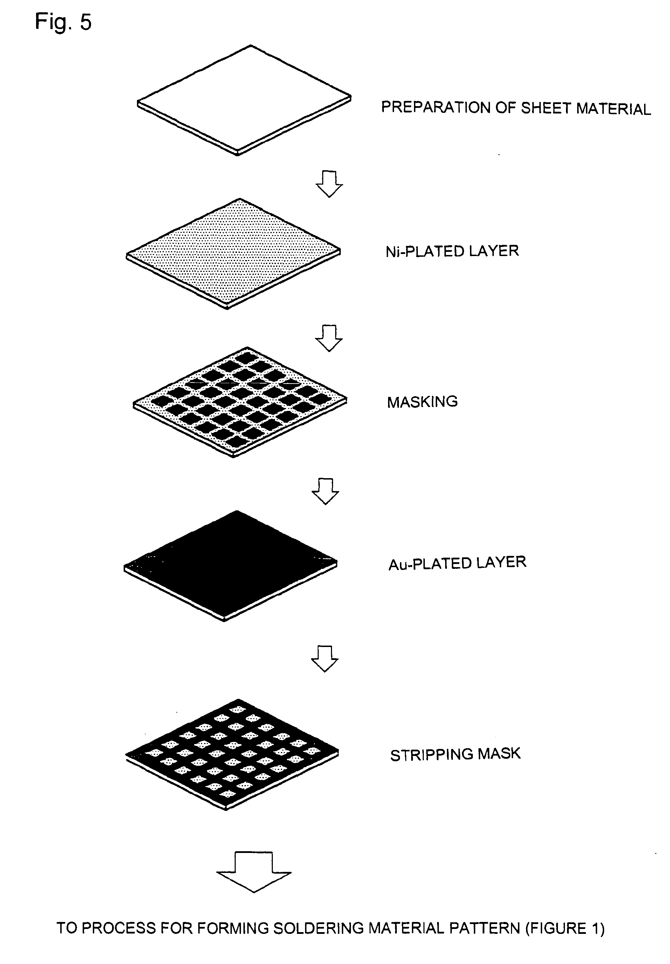

Example 1: A lid was manufactured with the use of the above described apparatus for forming the soldering material pattern. The process according to the example is illustrated in Fig. 5. The lid was manufactured through the steps of: preparing a sheet material made of kovar (dimension: 50 mm × 50 mm × 40 µm); plating the sheet material with Ni (1.5 µm); masking a portion corresponding to space parts in the case; and then plating the sheet material with Au (0.1 µm). The portion was masked so as to prevent the melted soldering material from spreading too far, because the Au plated film in this example is so thick that the soldering material shows excessively adequate wettability. It is determined by the thickness of the Au-plated film whether the masking operation is necessary or not. When the Au-plated film is 0.03 to 5 µm thick, the portion is preferably masked, but when the Au-plated film is thinner than 0.03 µm, the whole surface can be plated with Au without needing a masking operation because of no need to concern the spread of the soldering material.

After the Au-plated film has been formed, the mask was stripped and the ball-shaped soldering material was fixed. The ball-shaped soldering materials having a plurality of particle sizes were continuously fixed on the lid (sheet material) while the particle sizes of a droplet-shaped soldering material to be projected were controlled. The lid was thus manufactured. A plurality of thicknesses of the soldering material were set, which will be shown when the soldering material will be melted. The lid was cut into individual lids (5 mm × 5 mm), after having had the ball-shaped soldering material fixed thereon.

Then, a sealing test was carried out for the manufactured lid through using the cases with the same size. The sealing test includes the steps of: overlaying the lid on the case; heating them at 300°C; and examining the wettability of the soldering material and the presence (ratio) of voids by X-ray observation for the joined part. Simultaneously, a gross leak test was carried out to evaluate the airtightness. The result is shown in Table 1.

**[Table 1]**

| Fusion-bonding equivalent thickness | Ball-shaped soldering material | | Sealing test | | |
|---|---|---|---|---|---|
| | Ball diameter (µm) | Number (piece/mm²) | Void ratio (%) | Wettability | Gross leak test |
| 5 µm | 5 | 76394.4 | 1.8 | ○ | × |
| | 30 | 353.7 | 1.1 | ⊚ | ⊚ |
| | 80 | 18.7 | 0.8 | ⊚ | ⊚ |
| | 120 | 5.5 | 1.6 | ⊚ | ⊚ |
| | 200 | 1.2 | 1.5 | × | × |
| | 300 | 0.4 | 15.5 | × | × |
| 10 µm | 5 | 152788.7 | 1.5 | ○ | ⊚ |
| | 30 | 707.4 | 0.5 | ⊚ | ⊚ |
| | 80 | 37.3 | 1.1 | ⊚ | ⊚ |
| | 120 | 11.1 | 0.6 | ⊚ | ⊚ |
| | 200 | 2.4 | 0.4 | △ | ⊚ |
| | 300 | 0.7 | 12.8 | △ | ○ |
| 15 µm | 5 | 229183.1 | 0.3 | △ | ⊚ |
| | 30 | 1061 | 0.6 | ⊚ | ⊚ |
| | 80 | 56 | 0.2 | ⊚ | ⊚ |
| | 120 | 16.6 | 0.5 | ⊚ | ⊚ |
| | 200 | 3.6 | 0.4 | ⊚ | ⊚ |
| | 300 | 1.1 | 8.3 | △ | ○ |
| 20 µm | 5 | 305577.5 | 0.6 | △ | ⊚ |
| | 30 | 1414.7 | 0.3 | ⊚ | ⊚ |
| | 80 | 74.6 | 0.3 | ⊚ | ⊚ |
| | 120 | 22.1 | 0.2 | ⊚ | ⊚ |
| | 200 | 4.8 | 0.5 | ⊚ | ⊚ |
| | 300 | 1.4 | 0.5 | ⊚ | ⊚ |

| | | | | | |
|---|---|---|---|---|---|
| Wettability ... ⊚ excellent ○ good Δ partially poor × poor Gross leak test ... ⊚ excellent (no leak) ○ good (almost no leak) × poor (remarkable leak) | | | | | |

Example 2: Here, a case was manufactured which had a ball-shaped soldering material fixed thereon. A base material was prepared which had pores (not penetrating) having the internal dimension of 4 mm × 4 mm and the depth of 0.6 mm regularly formed therein, was plated with Ni (3.5 µm), and was further plated with Au (0.1 µm). Then, the ball-shaped soldering material was fixed while the particle size of the droplet-shaped soldering material was controlled, and the base material was cut into individual cases (5 mm × 5 mm), similarly to the steps in Example 1.

Subsequently, the manufactured cases were subjected to the sealing test after the lid having the same size with the case had been joined, similarly to that in Example 1. The result is shown in Table 2.

**[Table 2]**

| Fusion-bonding equivalent thickness | Ball-shaped soldering material | | Sealing test | | | |
|---|---|---|---|---|---|---|
| | Ball diameter (µm) | Number (piece/mm²) | Void ratio (%) | Wettability | Appearance | Gross leak test |
| 5 µm | 5 | 76394.4 | 1.2 | ○ | △ | × |
| | 30 | 353.7 | 1.3 | ⊚ | O | ⊚ |
| | 80 | 18.7 | 1.6 | ⊚ | ⊚ | ⊚ |
| | 120 | 5.5 | 1.8 | ⊚ | ⊚ | ⊚ |
| | 200 | 1.2 | 1.7 | × | △ | × |
| | 300 | 0.4 | 10.5 | × | △ | × |
| 10 µm | 5 | 152788.7 | 0.7 | ○ | △ | ⊚ |
| | 30 | 707.4 | 0.5 | ⊚ | ⊚ | ⊚ |
| | 80 | 37.3 | 1.3 | ⊚ | ⊚ | ⊚ |
| | 120 | 11.1 | 0.8 | ⊚ | ⊚ | ⊚ |
| | 200 | 2.4 | 0.6 | △ | ⊚ | ⊚ |
| | 300 | 0.7 | 13.2 | △ | △ | × |
| 15 µm | 5 | 229183.1 | 0.3 | △ | △ | ⊚ |
| | 30 | 1061 | 0.5 | ⊚ | ⊚ | ⊚ |
| | 80 | 56 | 0.3 | ⊚ | ⊚ | ⊚ |
| | 120 | 16.6 | 0.6 | ⊚ | ⊚ | ⊚ |
| | 200 | 3.6 | 0.8 | ⊚ | ⊚ | ⊚ |
| | 300 | 1.1 | 3.5 | △ | ○ | × |
| 20 µm | 5 | 305577.5 | 0.8 | △ | △ | ⊚ |
| | 30 | 1414.7 | 0.4 | ⊚ | O | ⊚ |
| | 80 | 74.6 | 0.6 | ⊚ | ⊚ | ⊚ |
| | 120 | 22.1 | 0.5 | ⊚ | ⊚ | ⊚ |
| | 200 | 4.8 | 0.4 | ⊚ | O | ⊚ |
| | 300 | 1.4 | 0.6 | ⊚ | ○ | ⊚ |

| | | | | | | |
|---|---|---|---|---|---|---|
| Appearance ... ⊚ excellent ○ good Δ partially poor * The content of evaluation for the wettability and the gross leak test are the same as in Table 1. | | | | | | |

From the results of Example 1 and Example 2, it is understood that when the equivalent thickness after fusion-bonding is thick, the package can be sealed regardless of the particle size of the ball-shaped soldering material. On the other hand, when the equivalent thickness after fusion-bonding is thin, a soldering material to be applied preferably has an appropriate range of particle sizes. The preferred particle size of the ball-shaped soldering material is 30 to 120 µm, because the fusion-bonding equivalent thickness is required to be thin in order to lower the height of the package.

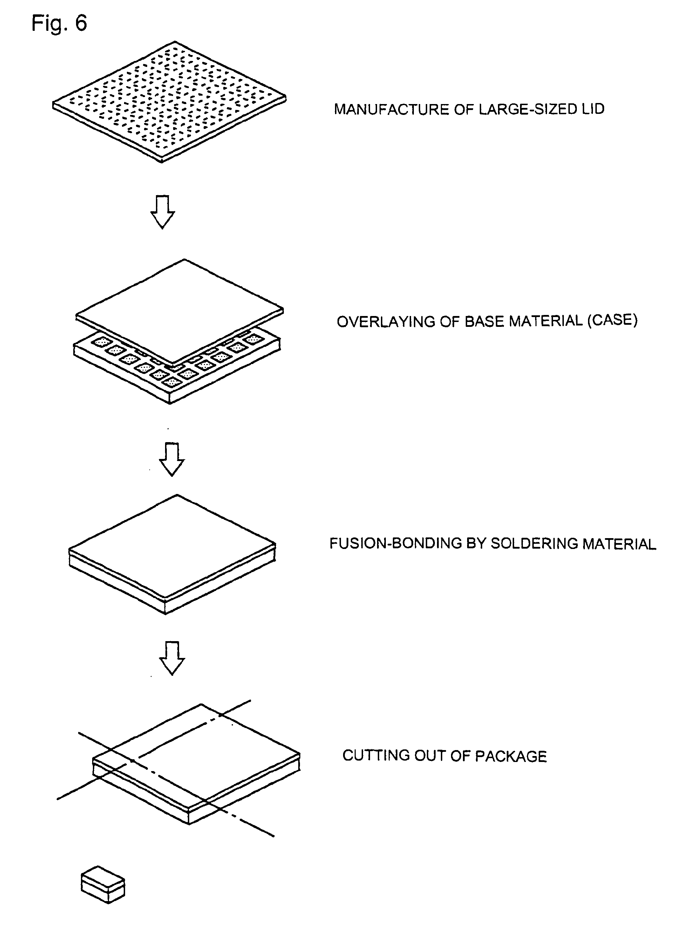

Second embodiment: Here, a large-sized lid was manufactured, and packages were collectively sealed by using the large-sized lid. The overviews of these steps are illustrated in Fig. 6. The large-sized lid was manufactured by the steps of: preparing a sheet material made of kovar similar to that in Example 1 in the first embodiment; plating the sheet material with Ni (1.5 µm); masking portions corresponding to space parts in the case; then plating the sheet material with Au (0.1 µm); stripping the mask; and fixing a ball-shaped soldering material (particle size of 200 µm) on the sheet material with the apparatus similar to that in the first embodiment. The arrangement pattern formed by the ball-shaped soldering material at this time was similar to the aspect in Fig. 2(B).

The large-sized lid manufactured in this way was overlaid on the same base material as in Example 2 in the second embodiment, was temporarily fixed, was subjected to a reflow step (heating) of 300°C to fusion-bond the packages with the soldering material. Then, the fusion-bonded material was cut into individual packages, and a plurality of packages were obtained. Some packages were randomly extracted from the plurality of the manufactured packages and were subjected to a gross leak test. As a result, none of the packages showed a sealing leak.

### Industrial Applicability

The above described lid or case for use in sealing a package according to the present invention can sufficiently cope with the tendency of lowering the height of and reducing the thickness of the package for electronic parts. The lid or the case does not generate gas when the package is sealed, and does not give an influence to an element in the package. The lid or the case according to the present invention is manufactured by directly fixing a soldering material which has been formed into a droplet of a molten state on a lid or a case, and decreases the manufacturing steps.

## Claims

1. A lid or a case for a sealed package, which is provided with a frame-shaped soldering material on its face to be joined, wherein the frame-shaped soldering material is formed of aligned ball-shaped soldering materials having particle sizes of 10 to 300 µm.

2. The lid or the case for the sealed package according to claim 1, wherein the ball-shaped soldering materials have particle sizes of 30 to 120 µm.

3. The lid or the case for the sealed package according to claim 1 or claim 2, wherein the ball-shaped soldering materials are continuously arranged so that the soldering materials contact each other.

4. The lid or the case for the sealed package according to any one of claims 1 to 3, wherein the ball-shaped soldering materials are stacked into layers.

5. The lid or the case for the sealed package according to any one of claims 1 to 4, wherein the soldering material includes an Au-Sn-based soldering material, an Au-Ge-based soldering material, an Au-Si-based soldering material and an Au-Sb-based soldering material.

6. A method for manufacturing the lid or the case, the lid or the case being defined in any one of claims 1 to 5, comprising the steps of:
(1) forming a droplet from the soldering material in a molten state;
(2) discharging the soldering material which has been formed into the droplet onto the face to be joined of the lid or the case to fix the ball-shaped soldering material on the face; and
(3) repeating the steps (1) and (2).

7. A method for manufacturing the lid or the case for the sealed package according to any one of claims 1 to 5 comprising the steps of:
(a) preparing a sheet material comprising a plurality of lids, or a base material comprising a plurality of cases;
(b) discharging the soldering material which has been formed into a droplet to a portion corresponding to the face to be joined of the lid or the case on the sheet material or the base material to fix the ball-shaped soldering material on the face and form a pattern formed of a plurality of frame shapes; and
(c) cutting and separating the sheet material or the base material into individual lids or cases.

8. A large-sized lid for a sealed package formed of a sheet material which can integrally form a plurality of lids, wherein the large-sized lid has ball-shaped soldering materials aligned on its face to be joined at which the plurality of the lids are joined with cases.

9. The large-sized lid according to claim 8, wherein the ball-shaped soldering materials are arranged on at least a first set point corresponding to a corner part among the lids to be joined.

10. The large-sized lid according to claim 9, wherein at least one ball-shaped soldering material is further arranged in between the first set points.

11. The large-sized lid according to claim 1, wherein the ball-shaped soldering material has a particle size of 30 to 120 µm.

12. The large-sized lid according to any one of claims 1 to 4, wherein the soldering material includes an Au-Sn-based soldering material, an Au-Ge-based soldering material, an Au-Si-based soldering material and an Au-Sb-based soldering material.

13. A method for manufacturing the large-sized lid for the sealed package according to any one of claims 8 to 12 comprising the steps of:
(a) preparing a sheet material which can integrally form a plurality of lids; and
(b) discharging the soldering material which has been formed into a droplet onto the sheet material to fix the ball-shaped soldering material on the sheet material.

14. A method for sealing a package through using the large-sized lid according to any one of claims 8 to 12 comprising the steps of:
(a) manufacturing the large-sized lid;
(b) preparing an integrated base material which is provided with a plurality of cases having an element contained therein; and
(c) overlaying the large-sized lid on the base material and then fusion-bonding the large-sized lid with the soldering material.
